# EUROPÄISCHE PATENTANMELDUNG

(11) **EP 2 653 222 A2**
(43) Veröffentlichungstag der Anmeldung: **23.10.2013**
(21) Anmeldenummer: 13401033.9
(22) Anmeldetag: 09.04.2013
(51) Int. Cl.: B01L 3/00, G03F 7/00

(54) **Mikrostrukturapparat mit optischer Oberflächengüte sowie Verfahren zur Herstellung desselben**

(30) Priorität: 16.04.2012 DE 102012103256
(71) Anmelder: Karlsruher Institut für Technologie, 76131 Karlsruhe (DE)
(72) Erfinder: Anurjew, Eugen, 75180 Pforzheim (DE); Brandner, Jürgen, 69207 Sandhausen (DE); Hansjosten, Edgar, 76149 Karlsruhe (DE); Li, Yongli, 31400 Toulouse France (FR); Newport, David, Co. Clare Ireland, Ardnacrusha (IE)

(57) **Zusammenfassung**

Mikrostrukturapparat, umfassend eine Mikrokavität **(3).** Die Aufgabe liegt darin, einen Mikrostrukturapparat mit mindestens einer individuell gestaltbaren Mikrokavität so zu gestalten, dass eine Beobachtung des Innenvolumens der Mikrokavität mit optischen oder akustischen Mitteln begünstigt wird. Die Aufgabe wird dadurch gelöst, dass die an die Mikrokavität angrenzenden Oberfläche eines Festkörper **(1)** mit einer optischer Oberflächengüte aufweist und die Mikrokavität von einer auf dem Festkörper nach dem Prinzip des Rapid-Prototyping mittels Stereolithographie oder mittels selektivem Laserschmelzverfahrens aufgebauten dreidimensionalen Struktur **(2)** umgeben ist.

## Beschreibung

Die Erfindung betrifft einen Mikrostrukturapparat, vorzugsweise umfassend mindestens eine Mikrokavität mit Kanälen, Strömungsvolumina und/oder Reaktionsvolumina mit einer optischen Oberflächengüte sowie ein Verfahren zur Herstellung des Mikrostrukturapparats mit Mikrokavitäten mit einer optischen Oberflächengüte nach dem Prinzip des Rapid-Prototyping mittels Stereolithographie oder mittels selektivem Laserschmelzverfahrens (Selective Laser melting, SLM-Verfahren) gemäß des ersten bzw. siebenten bzw. neunten Patentanspruchs.

Für die Untersuchung von fluidischen Vorgängen in Kavitäten wie z.B. Strömungsvorgänge in Kanälen oder Reaktionen oder Phasenänderungen in Reaktionsvolumina ist eine optische Überwachung von Vorteil. Eine optische Überwachung erfolgt dabei entweder im visuellen Bereich, vorzugsweise mit bildgebenden Verfahren wie z.B. mit Kameras oder Mikroskopen in Auf-, Schnitt- oder Durchlichtansichten, alternativ mit Streulicht-oder Extinktionsverfahren wie z.B. Lichtschrankenüberwachungen oder andere Lichtabsorptionsverfahren.

Für die genannten optischen Phasen ist jedoch eine visuelle Schnittstelle zum Fluid in der Kavität erforderlich. Dies erfolgt üblicherweise über Sichtfenster oder andere optisch durchlässige Kavitätswandungen. Aufgrund der zur Verfügung stehenden Abmessungen ist diese Schnittstelle bei Mikrokavitäten ausschließlich durch die Kavitätswandungen realisierbar. Für einen optimalen Durchtritt von Lichtsignalen durch diese Kavitätswandungen müssen diese nicht nur transparent sein, sondern müssen zudem eine optische Oberflächengüte aufweisen. Optische Oberflächengüte bedeutet im Rahmen der Anmeldung eine Oberfläche, die einen einfallenden Lichtstrahl definierter Wellenlänge oder einem definierten Wellenlängenbereich ohne Streuung reflektiert oder durchlässt (mit oder ohne Brechung). Dies schließt eine Aufteilung eines Lichtstrahls über eine Teildurchlässigkeit und / oder Teilreflexion ebenso ein wie eine selektive Durchlässigkeit oder Reflexion bestimmter Wellenlängen durch Filterung. Der Wellenlängenbereich umfasst sowohl das sichtbare als auch das unsichtbare Wellenlängenspektrum (d.h. inkl. UV-Infrarot und Röntgenspektren).

Eine Realisierung der genannten Schnittstellen bei makroskopischen Kavitäten ist in der Regel z.B. durch eingesetzte Sichtfenster problemlos, aber nicht ohne weiteres auf den visuellen Zugang in mikrostrukturierte Kavitäten übertragbar.

Beispielhaft zeigt die DE 41 32 379 A1 einen Mikro-Bioreaktor mit einer Vielzahl von an- und durchströmbaren Zellkulturgefäße, die zwischen zwei plane Glasplatten dichtend eingesetzt sind und damit Veränderungen in der Zellkultur in einem Lichtmikroskop beobachtet werden können.

In der Mikrostruktur- und Mikroverfahrenstechnik sind auch Systeme bekannt, bei der Mikrokanäle und andere Kavitäten in ein transparentes Material eingearbeitet werden und so eine Beobachtung der Mischvorgänge oder Reaktionen ermöglichen.

DE 100 25 699 A1 offenbart beispielhaft ein Emulgier- und Trennvorrichtung, bei denen Kanäle u.A. in Glasplatten eingearbeitet sind.

Die bekannten Vorrichtungen weisen jedoch nur eingeschränkte geometrische Gestaltungsmöglichkeiten der Mikrokavitäten auf, wenn die optische Qualität der Sichtfensterbereiche einzuhalten ist. In transparente Körper eingearbeitete Mikrokavitäten weisen zwar eine erhöhte Gestaltungsfreiheit auf, weisen aber in den Kanälen nur eingeschränkte optische Eigenschaften auf.

Davon ausgehend liegt die **Aufgabe der Erfindung** darin, einen Mikrostrukturapparat mit mindestens einer individuell gestaltbaren Mikrokavität so zu gestalten, dass eine Beobachtung des Innenvolumens der Mikrokavität mit optischen oder akustischen Mitteln begünstigt wird. Weiterhin liegt eine Aufgabe darin, ein Verfahren zur Herstellung desselben vorzuschlagen.

Die Aufgabe wird durch einen Mikrostrukturapparat mit Merkmalen von Anspruch 1 sowie ein Verfahren mit Merkmalen von Anspruch 7 und 9 gelöst. Unteransprüche geben vorteilhafte Ausgestaltungen wieder.

Gelöst wird die Aufgabe durch einen Mikrostrukturapparat mit Mikrokavität, die direkt an die Oberflächen mindestens eines Festkörper mit einer optischen Oberflächengüte angrenzt, ansonsten aber durch eine nach dem Prinzip des Rapid-Prototyping mittels Stereolithographie oder mittels selektivem Laserschmelzverfahrens (SLM) aufgebauten dreidimensionalen Struktur umschlossen und begrenzt ist.

Das Rapid-Prototyping mittels Stereolithographie ist ein bekanntes Verfahren zur Herstellung von Strukturen. Es umfasst einen schichtweisen Aufbau einer dreidimensionalen Struktur aus einem lichtaushärtenden Kunststoff. Ausgangsstoff ist ein lichtaushärtendes Monomer, das in einem Bad mit fokussiertem Laserlicht polymerisiert wird. Die im Bad entstehende Polymerstruktur entsteht schichtweise durch Belichtung von Monomer im Bereich der Flüssigkeitsoberfläche mit stufenweisem Absenken nach jedem Belichtungszyklus.

Entsprechend ist das Rapid-Prototyping mittels selektivem Laserschmelzverfahrens (SLM-Verfahren) ein Verfahren, bei dem aus Partikel oder Pulver eines schmelz- oder sinterfähigen Materials wie vorzugsweise mindestens eines Metalls oder einer Metalllegierung, Glas, Halbleiter und/oder Keramik wie Metalle oder Keramik schichtweise durch Aufsintern oder Aufschmelzen der Pulver eine dreidimensionale Struktur vorzugsweise als Mikrostruktur hergestellt wird.

Wesentlich ist, dass die genannte dreidimensionale Struktur direkt auf die Oberfläche mit optischer Oberflächengüte des Festkörpers aufgebaut wird. Hierzu wird die Oberfläche zunächst im Bad mit einem flüssigen photosensitiven Monomer eingelegt, wobei die optische Oberfläche bevorzugt parallel unmittelbar unter der Flüssigkeitsoberfläche angeordnet ist. Entsprechend wird bei einem SLM-Verfahren das Pulver direkt auf der Oberfläche aufgeschmolzen oder in einem Diffusions-oder molekularen Umlagerungsprozess aufgesintert und damit eine stoffschlüssige Verbindung hergestellt. Es erfolgt ein bevorzugt schichtweiser Aufbau der dreidimensionalen Struktur um die Mikrokavitäten nach dem Prinzip des vorgenannten Rapid-Prototyping mittels Stereolithographie oder SLM. Die Mikrokavitäten grenzen somit direkt an die Oberfläche mit optischer Oberflächengüte des Festkörpers an. Nach Erzeugung der dreidimensionalen Struktur erfolgt eine Reinigung, z.B. mit Isopropanol sowie eine etwa 1 bis 2 Stunden andauernden Temperung bei 50 - 100°C, vorzugsweise bei 75 - 85°C, des Mikrostrukturapparats. Die Temperung bewirkt eine weitere Aushärtung der dreidimensionalen Struktur sowie dessen bessere Anbindung an den Festkörper. Isopropanol löst vorteilhaft das Monomer, nicht aber das ausgehärtete Polymer der Struktur.

Die Festkörper sind entsprechend der erforderlichen optischen Eigenschaften vorzugsweise Platten oder Flächen aus Metall, Halbleitern (z.B. Silizium), Glas oder Keramik.

Platten eignen sich insbesondere für ausgewählte Wellenlängen transparente Sichtfenster. Sie sind vorzugsweise planparallel und/oder eben und weisen beidseitig bevorzugt poliert eine maximale Rauigkeit von wenigen Nanometern (kleiner 100nm, vorzugsweise kleiner 10nm) auf, die eine Streuung beim Lichtdurchtritt durch die Oberfläche zumindest bis auf eine vernachlässigbare Reststreuung vermeidet. Sichtfenster sind je nach durchtretenden Wellenlängen aus Glas (bevorzugt Quarzglas z.B. für sichtbares Licht und UV-Licht), Keramik oder Silizium (z.B. für Röntgenstrahlung, Silizium für Infrarotstrahlung) oder aus Metall (z.B. für Ultraschalleinkopplung). Soll der Lichtdurchtritt weiter selektiert werden, kommen Filterplatten, z.B. Verbundplatten mit mehreren Schichten oder Beschichtungen auf einer Platte bevorzugt zum Einsatz.

Für einen Einsatz als Spiegelfläche weist der Festkörper bevorzugt eine polierte Fläche auf (optischer Spiegel, vorzugsweise beschichtetes Glas, poliertes Aluminium, Messing etc.). Ist eine Bragg'sche Reflexion z.B. für die Erzeugung von Interferenzen (z.B. für Strömungs- und Durchflussmessungen) vorgesehen, muss die bevorzugt polierte Fläche die Oberfläche eines kristallinen Stoffes (integriertes Bragg-Gitter) sein. Die an die Kavität angrenzende Oberfläche ist vorzugsweise aus Metall, wobei entweder der Festkörper oder eine auf diesen aufgetragene Beschichtung aus Metall sind.

Weiterhin sind auch an die Kavität angrenzende Streuflächen auf dem Festkörper denkbar, die sich durch eine Oberflächentopographie und/oder Rauigkeit von mindestens der Größenordnung der gestreuten Strahlungswellenlänge oder eines Vielfachen davon auszeichnen. Damit werden Lichtstrahlen, die durch die Oberfläche durchtreten oder reflektiert werden zusätzlich gestreut, womit sich in vorteilhafter Weise eine Homogenisierung einer Ausleuchtung in der Mikrokavität realisieren und z.B. bei photoaktiven Reaktionen in der Mikrokavität nutzen lässt. Eine bevorzugte Ausführung des Mikrostrukturapparats umfasst eine Mikrokavität, die an zwei oder mindestens zwei Festkörpern mit einer optischen Oberflächengüte angrenzt. Vorzugsweise sind die beiden Festkörper Platten und in vorgenannter Weise als Sichtfenster konzipiert. Sie ermöglichen z.B. Streulichtmessungen oder Extinktionsmessungen in der Kavität, indem durch ein Sichtfenster eine Strahlung einleitbar und vorzugsweise durch das andere Sichtfenster eine Messung von Streulicht bzw. Schattenstrukturen realisierbar ist.

Weiter bevorzugt ist die Mikrokavität zwischen zwei planparallelen Oberflächen der beiden Festkörper angeordnet. Die Festkörper sind vorzugsweise transparente Platten oder Prismenkörper, wenn die optische Oberfläche Durchtrittsebenen für eine Lichtstrahlung ist.

Die Herstellung eines Mikrostrukturapparat mit vorgenannter Mikrokavität mit zwei oder mehr Festkörpern erfolgt vorzugsweise durch Positionierung der Festkörper im Bad oder Pulver und anschließender schichtweisen stereolithographischer Umwandlung von Monomerbestandteile in die dreidimensionale Struktur oder einer Herstellung der Struktur mittels des SLM-Verfahrens. Vorzugsweise werden die optischen Oberflächen der Festkörper nicht parallel zur Badoberfläche im Monomer angeordnet, die für die Aushärtung erforderlichen Lichtstrahlen nicht durch die Festkörper geleitet.

Alternativ umfasst das Verfahren zur Herstellung eines Mikrostrukturapparats mit einer Mikrokavität mit zwei oder mehr Festkörpern einen schichtweisen Aufbau eines Strukturkörpers oder einer Struktur mit einem offenen Kanal auf einer Festkörperoberfläche. Dieser offene Kanal wird anschließend nach Herausnahme aus dem Monomerbad und einer Reinigung z.B. mit Isopropanol durch einen zweiten Festkörper abgedeckt und durch eine anschließende Temperung (vorzugsweise etwa 1 bis 2 Stunden andauernden Temperung bei 50 - 100°C, vorzugsweise bei 75 - 85°C) mit diesem verbunden. Es entsteht damit eine beidseitig durch je eine Festkörperoberfläche begrenzte Mikrokavität.

Der genannte Temperaturbereich der Temperung ändert sich im Rahmen des SLM-Verfahrens mit dem Material für die Struktur und/oder für den Festkörper. Eine diffusionsgesteuerte Umlagerung von Materialbestandteilen ermöglicht nicht nur einen Sinterprozess, sondern auch ein Diffusionsverschweißen von Struktur und Festkörper ermöglicht. Diese Umlagerung erfolgt im Rahmen der Erfindung erfolgt die Temperung bei einer Temperatur, die ein Diffusionsverschweißen ermöglicht, d.h. vorzugsweise beim 0,6- bis 0,9-fachen der Schmelztemperatur des jeweils niedriger schmelzenden Materials von Struktur oder Festkörper in Kelvin oder bevorzugt bei 400-600°C.

Das Verfahren zur Herstellung von Mikrokavitäten mit optischer Oberflächengüte umfasst vorzugsweise einen vorgeschalteten Schritt mit einer Aufrauhung der Oberfläche des Festkörpers vor einer ersten Benetzung mit dem Monomer. Vorzugsweise erstreckt sich der Bereich nur über die gemeinsame Kontaktfläche zur dreidimensionalen Struktur und lässt dabei zumindest den Bereich des direkten Kontakts zur Mikrokavität (Sichtfensters oder der optischen Oberfläche) ganz oder teilweise aus. Damit wird in vorteilhafter Weise eine bessere Haftung zwischen Festkörper und Struktur ermöglicht. Die Aufrauhung erfolgt vor dem Eintauchen in das Bad bevorzugt durch Laserbehandlung.

Bestimmte Ausführungen sehen vor, auch im vorgenannten Bereich des Sichtfensters oder der optischen Oberfläche ebenfalls zu modifizieren. Neben der zuvor genannten Ausgestaltung einer Bragg'schen Reflexionsebene lassen sich auch Beschichtungen, Strukturen oder Aufrauhungen realisieren, die eine selektive oder nicht selektive Anbindung zu bestimmten Stoffen oder Zellen begünstigen. Die Beschichtung besteht optional aus katalytisch wirkenden Stoffen. Eine weitere Ausführung sieht vor, den Festkörper angrenzend zur Kavität mit einer Struktur zur Kultivierung von lebenden Zellen zu gestalten, beispielsweise mit einer Wellstruktur oder Zellkulturcontainern. Die Anbindungsdynamik lässt sich vorzugsweise in der vorgenannten Ausführung mit zwei planparallelen Oberflächen zweier Festkörper z.B. optisch im Durchlichtverfahren qualitativ und quantitativ überwachen bzw. messen.

Für eine Temperierung der Mikrokavität sind optional Temperierungsmittel vorgesehen, die bevorzugt in den Festkörper integriert sind oder in diesen einwirken. Eine Ausführung sieht vor, den Festkörper ganz oder nur abseits der Erstreckung der Mikrokavität als fluidischen Mikrowärmetauscher mit Mikrokanälen für ein Wärmeübertragungsfluid vorzusehen. Alternative Temperierungsmittel umfassen elektrische eingesetzte oder integrierte Heizelemente oder auch Peltier-Elemente sowie den Einsatz von Mirkowellen. Ergänzend oder alternativ sind, bevorzugt in mindestens der Festkörper, Sensoren (für Temperatur, Druck, Durchfluss, pH, optische Sensoren wie Spektrometer, Photozellen etc., elektrische Sensoren wie Leitfähigkeitsdetektoren etc.) oder elektrisch oder optisch aktive Elemente (elektromagnetische Spiegel, Ventile, Pumpen, oder optische Lichtleitfasern, LED, Luxdioden etc.) integriert oder eingesetzt.

Die Erfindung umfasst neben des Mikrostrukturapparats mit Mikrokavität und dem Verfahren zur Herstellung der Mikrokavität auch eine Verwendung des Verfahrens zur Herstellung der Mikrokavität sowie eine Verwendung der der Mikrokavität zur optischen Überwachung von Strömungs- und Reaktionsvorgängen.

Die Erfindung wird im Folgenden anhand von Ausführungsbeispielen mit Figuren näher erläutert. Es zeigen
**Fig.1** eine Draufsicht einer Struktur mit einer offenen Kanalanordnung auf einer ersten Platte aus Quarzglas in einem Monomerbad,
**Fig.2** eine Schnittdarstellung der in **Fig.1** dargestellten Ausführungsform mit der ersten Platte mit Struktur sowie eine auf diese Struktur aufgesetzte zweite Platte,
**Fig.3** die Schnittdarstellung gemäß **Fig.2** mit applizierten Fluidanschlüssen für die Kanalanordnung,
**Fig.4** eine perspektivische Schnittdarstellung eines Fluidanschlusses sowie
**Fig.5** eine Vorrichtung zur Versiegelung der Mikrokavität im Mikrostrukturapparat.

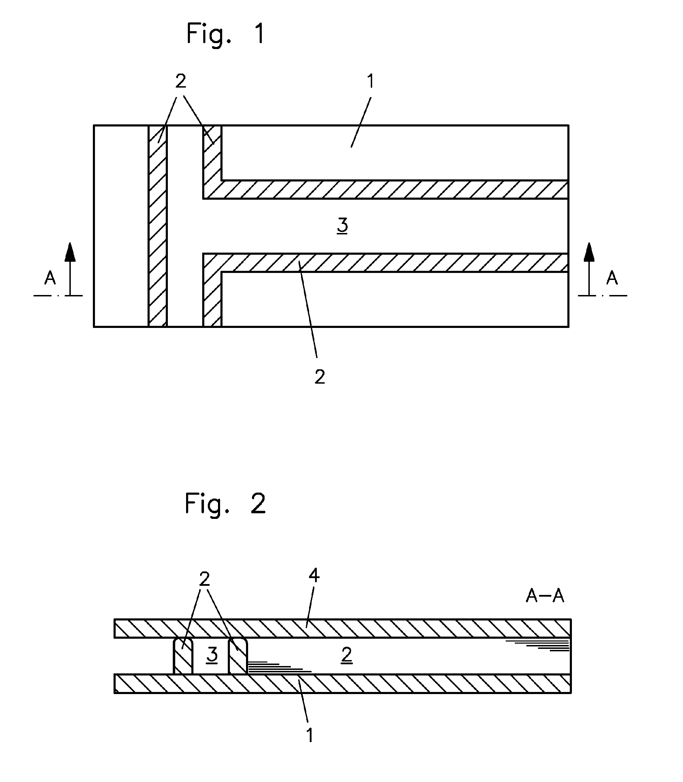

**Fig.1** zeigt die Draufsicht einer Ausführung des beanspruchten Mikrostrukturapparats mit Mikrokavität auf einem Festkörper, der durch eine ebene Platte **1** aus einem Quarzglas gebildet wird sowie einer auf diese aufgesetzte dreidimensionale Struktur, die durch Wandungsstrukturen **2** gebildet werden. Die beanspruchte Mikrokavität umfasst folglich im Rahmen dieser Anmeldung auch die angrenzenden Wandungselemente. Die Mikrokavität selbst wird durch eine Kanalstruktur **3** gebildet, die wiederum durch die Wandungen der Wandungsstrukturen und der Platte, d.h. den Wandungselementen begrenzt wird.

Die Kanalstruktur **3** ist zunächst zum Betrachter der **Fig.1** hin offen und wird nach Aufbau der Wandungsstrukturen **2** auf der ebenen Platte **1** nach dem Prinzip des Rapid-Prototyping mittels Stereolithographie durch einen zweiten Festkörper, d.h. im Beispiel eine Deckplatte **4** vorzugsweise ebenfalls aus Quarzglas als zweite ebene Platte abgedeckt. **Fig.2** zeigt eine Schnittdarstellung entsprechend der in **Fig.1** wiedergegebenen Schnittlinie **A-A** mit der auf die Wandungsstrukturen **2** auf der Platte **1** aufgesetzten Deckplatte **4,** die die Kanalstruktur **3** nach oben hin abschließt. Die stoffschlüssige Verbindung zwischen Wandungsstruktur und Deckplatte erfolgt wie vorgenannt bei der Temperung der Vorrichtung, wobei das Polymer der Wandungsstrukturen weiter ausgehärtet wird und sich an die bevorzugt aufgeraute Quarzglasoberfläche der Deckplatte anbindet. Während der Temperung erfolgt vorzugsweise ein flächiges Anpressen der Deckplatte auf die Wandungsstrukturen.

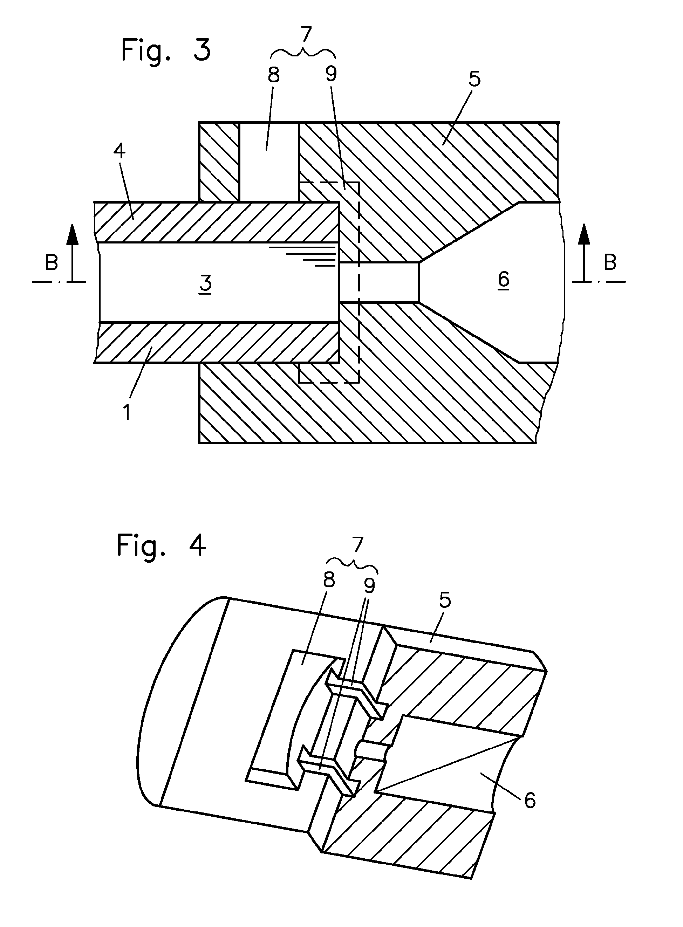

**Fig.3** und **Fig.4** geben ein fluidisches Anschlusselement **5** für die Mikrokavität wieder. **Fig.3** zeigt eine Schnittdarstellung dieses Elements, appliziert an die beiden Platte **1** und die Deckplatte **4.** Das vorzugsweise einstückige Anschlusselement wird auf die Mikrokavität aufgeschoben und die Kontaktfläche nach außen hin abgedichtet. Folglich umfasst das Anschlusselement eine Anschlussbohrung **6** für einen anzuschließenden Fluidstrom sowie ein Kanalsystem **7** mit Anguss **8** und einen um die Mikrokavität herumführenden Fluidsperrkanal **9** für eine Dichtmasse, vorzugsweise Silikon. Eine perspektivische Schnittdarstellung nur des Anschlusselements entsprechend der Schnittlinie **B-B** in **Fig.3** ist in **Fig.4** wiedergegeben.

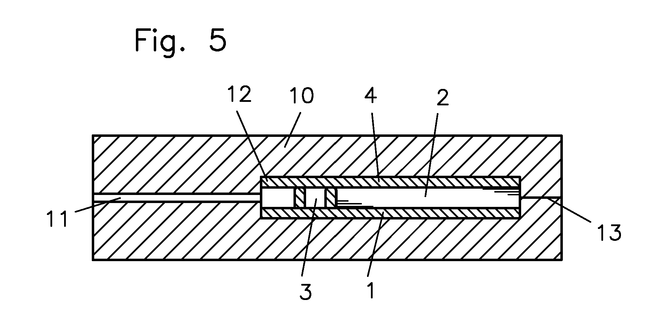

**Fig.5** zeigt eine Schnittdarstellung einer Versiegelungsform **10** vorzugsweise aus Gummi zum Einlegen und Versiegeln der Kanalstruktur **3** im Bereich der Platte **1,** der Wandungsstrukturen **2** und der Deckplatte **4.** Die Versiegelungsform einseitig zum Einlegen des Mikrostrukturapparats mit Mikrokavität über einem Schlitz **13** aufbiegbbar gestaltet und dichtet mit Einlegen der Mikrokavität in eine hierfür vorgesehene und angepasste Aussparung **12** diese nach außen hin ab. Eine Versiegelungsflüssigkeit, vorzugsweise ein Silikon wird über Einlasskanäle **11** in die verbleibenden Kavitäten der Aussparung eingeleitet und versiegelt damit die Mikrokavität.

### Bezugszeichenliste:

1 Platte
2 Wandungsstruktur
3 Kanalstruktur
4 Deckplatte
5 Anschlusselement
6 Anschlussbohrung
7 Kanalsystem
8 Anguss
9 Fluidsperrkanal
10 Versiegelungsform
11 Einlaskanal
12 Aussparung
13 Schlitz

## Patentansprüche

1. Mikrostrukturapparat, umfassend eine Mikrokavität **(3)** und eine an die Mikrokavität angrenzenden Oberfläche eines Festkörpers **(1)** mit einer optischen Oberflächengüte sowie einer auf dem Festkörper nach dem Prinzip des Rapid-Prototyping mittels Stereolithographie oder mittels selektivem Laserschmelzverfahrens aufgebauten dreidimensionalen Struktur **(2)** um die Mikrokavität.

2. Mikrostrukturapparat nach Anspruch 1, **dadurch gekennzeichnet, dass** ein zweiter Festkörper mit einer optischen Oberflächengüte an die Mikrokavität **(3)** angrenzt.

3. Mikrostrukturapparat nach Anspruch 1 oder 2, **dadurch gekennzeichnet, dass** der Festkörper Platten aus einem Glas, einem Glas mit Spiegelfläche, einer Keramik, einem Halbleiter, einem poliertem Metall oder Metall mit eingearbeiteten Bragg-Gitter ist.

4. Mikrostrukturapparat nach einem der vorgenannten Ansprüche, **dadurch gekennzeichnet, dass** die Mikrokavitäten Kanäle, Strömungsvolumina oder Reaktionsvolumina umfassen.

5. Mikrostrukturapparat nach einem der vorgenannten Ansprüche, **dadurch gekennzeichnet, dass** der Festkörper Temperierungsmittel aufweist.

6. Mikrostrukturapparat nach einem der vorgenannten Ansprüche, **dadurch gekennzeichnet, dass** der Festkörper Sensoren oder elektrisch oder optisch aktive Elemente aufweist.

7. Verfahren zur Herstellung eines Mikrostrukturapparat mit Mikrokavitäten mit optischer Oberflächengüte, umfassend die folgenden Verfahrensschritte
a) Einlegen mindestens eines Festkörpers mit einer optischen Oberflächengüte in ein Bad aus einem flüssigen photosensitiven Monomer,
b) Aufbau einer dreidimensionalen Struktur um die Mikrokavitäten nach dem Prinzip des Rapid-Prototyping mittels Stereolithographie aus einem flüssigen Monomer, wobei die Mikrokavitäten an den Festkörper angrenzen sowie
c) Reinigung und anschließende Temperung der Struktur.

8. Verfahren nach Anspruch 7, umfassend ein Einlegen mindestens eines zweiten Festkörpers mit einer optischen Oberflächengüte in das Bad aus flüssigem Monomer, sodass die Mikrokavitäten zwischen den zwei Festkörpern angeordnet sind und an beide angrenzen.

9. Verfahren zur Herstellung eines Mikrostrukturapparat mit Mikrokavitäten mit optischer Oberflächengüte, umfassend die folgenden Verfahrensschritte
d) Beschichten einer optischen Oberfläche eines Festkörpers mit einem Schicht aus Partikel mindestens eines Metalls oder einer Metalllegierung, Glas, Halbleiter und/oder Keramik,
e) Aufbau einer dreidimensionalen Struktur um die Mikrokavitäten nach dem Prinzip des Rapid-Prototyping mittels selektivem Laserschmelzverfahrens durch selektives Sintern oder Schmelzen der Struktur aus der Pulverschicht, wobei die Mikrokavitäten an den Festkörper angrenzen sowie
f) Reinigung und anschließende Temperung der Struktur.

10. Verfahren nach einem der Ansprüche 7 bis 9, umfassend einen vorgeschalteten Schritt mit einer Aufrauhung und/oder Beschichtung der Oberfläche des Festkörpers vor einer ersten Benetzung mit dem Monomer oder vor einem ersten Laserschmelzen oder Lasersintern.
